# EUROPEAN PATENT APPLICATION

(11) **EP 4 807 375 A1**
(43) Date of publication of application: **16.09.2026**
(21) Application number: 24888501.4
(22) Date of filing: 21.10.2024
(51) Int. Cl.: G01R 19/00, G01K 1/14, G01K 7/00, H01M 10/48, H02J 7/00, H02J 7/04

(54) **POWER STORAGE PACK**

(30) Priority: 08.11.2023 JP 2023191048
(71) Applicant: Panasonic Intellectual Property Management Co., Ltd., Kadoma-shi, Osaka 571-0057 (JP)
(72) Inventor: HAMAMOTO, Katsuaki, Kadoma-shi, Osaka 571-0057 (JP)
(74) Representative: Novagraaf International SA
(86) International application number: PCT/JP2024/037324
(87) International publication number: WO 2025/100203

(57) **Abstract**

A controller acquires measurement values from a temperature sensor via signal lines of a plurality of systems. The systems comprise two or more selected from the group consisting of: a first system in which no high-frequency filter is provided on both a positive signal line connected to one of terminals of the temperature sensor and a negative signal line connected to the other of the terminals; a second system in which a high-frequency filter is provided on either a positive signal line connected to one of terminals of the temperature sensor or a negative signal line connected to the other of the terminals; or a third system in which a high-frequency filter is provided on both a positive signal line connected to one of terminals of the temperature sensor and a negative signal line connected to the other of the terminals. The controller compares two or more measurement values acquired from the signal lines of the two or more systems to determine whether at least of the measurement values includes noise.

## Description

### TECHNICAL FIELD

The present disclosure relates to a power storage pack including a temperature sensor.

### BACKGROUND ART

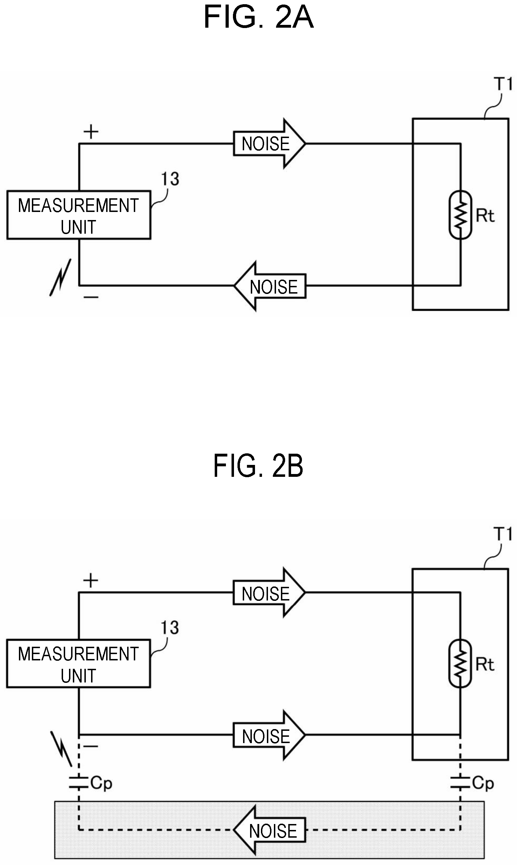

A temperature sensor using a negative temperature coefficient (NTC) thermistor is generally mounted on a battery pack for the purpose of measuring the temperature of a battery, a bus bar, or the like. When noise in a normal (differential) mode (see Fig. 2A) or a common mode (see Fig. 2B) enters the temperature sensor and a current flowing through the thermistor or an applied voltage changes, an error occurs in a temperature measurement value in a measurement circuit. Due to the error of the temperature measurement value, a control error occurs in a microcontroller at the subsequent stage, or the accuracy of estimating state of charge (SOC) decreases.

Patent Literature 1 discloses a method for determining whether or not thermistors TH1 to TH3 are abnormal by comparing a preset relationship between the levels of temperature data of the thermistors TH1 to TH3 and an acquired relationship between the levels of the temperature data of the thermistors TH1 to TH3 (see Figs. 1 and 2 of PTL 1).

Patent Literature 2 discloses a temperature abnormality detection sensor in which a plurality of temperature detectors is connected in series. Each temperature detector includes an antifuse circuit in which an antifuse element and a resistive element are connected in series, and a positive temperature coefficient (PTC) thermistor connected in parallel. When the temperature is normal, the combined resistance value of the temperature detector is substantially equal to the resistance value of the PTC thermistor. When the temperature is abnormal, the antifuse element transitions from an insulation state to a conduction state, and the combined resistance value of the temperature detector becomes substantially equal to the resistance value of the resistive element. By setting the resistance values of the resistive elements of the temperature detectors to different values, it is possible to specify which temperature detector is abnormal (see Fig. 1 of PTL 2).

### Citation List

Patent Literature
PTL 1: Unexamined Japanese Patent Publication No. 2012-122930
PTL 2: Unexamined Japanese Patent Publication No. 2013-24718

### SUMMARY OF THE INVENTION

The methods disclosed in PTLs 1 and 2 are based on the premise that a plurality of temperature sensors is installed, and are difficult to be applied to a configuration in which only one temperature sensor is installed. The inventor of the present invention has developed a highly versatile technology for determining the influence of noise on a measurement value of a temperature sensor with high accuracy.

The present disclosure has been made in view of the above circumstance, and an object thereof is to provide a technology for determining an influence of noise on a measurement value of a temperature sensor with high accuracy.

In order to solve the above problem, a power storage pack according to an aspect of the present disclosure includes: a temperature sensor that measures a temperature at a predetermined position in the power storage pack; and a controller that acquires measurement values from the temperature sensor via signal lines of a plurality of systems. The signal lines of the plurality of systems comprise signal lines of two or more systems selected from the group consisting of: a first system in which no high-frequency filter is provided on both a positive signal line connected to one of terminals of the temperature sensor and a negative signal line connected to another of the terminals, a second system in which a high-frequency filter is provided on either a positive signal line connected to one of terminals of the temperature sensor or a negative signal line connected to another of the terminals, or a third system in which a high-frequency filter is provided on both a positive signal line connected to one of terminals of the temperature sensor and a negative signal line connected to another of the terminals. The controller compares two or more measurement values acquired from the signal lines of the two or more systems to determine whether at least one of the measurement values includes noise.

According to the present disclosure, it is possible to determine the influence of noise on the measurement value of the temperature sensor with high accuracy.

### BRIEF DESCRIPTION OF THE DRAWINGS

Fig. 1 is a diagram for describing the configuration of a battery pack according to an exemplary embodiment.
Fig. 2A is a diagram illustrating a propagation path of normal mode noise entering a temperature sensor.
Fig. 2B is a diagram illustrating a propagation path of common mode noise entering a temperature sensor.
Fig. 3 is a diagram illustrating an electrical connection mode of a thermistor.
Fig. 4 is a graph showing a relationship between a temperature and a resistance value of a certain thermistor, and a relationship between the resistance value of the thermistor and an output voltage.
Fig. 5 is a diagram illustrating a first configuration example of a temperature measurement system in the battery pack according to the exemplary embodiment.
Fig. 6 is a graph illustrating comparison results of temperature measurement values acquired from signal lines of three systems and determination details according to the comparison results.
Fig. 7 is a diagram illustrating a second configuration example of the temperature measurement system in the battery pack according to the exemplary embodiment.
Fig. 8 is a graph illustrating comparison results of temperature measurement values acquired from signal lines of two systems and determination details according to the comparison results.
Fig. 9 is a diagram illustrating a third configuration example of the temperature measurement system in the battery pack according to the exemplary embodiment.

### DESCRIPTION OF EMBODIMENT

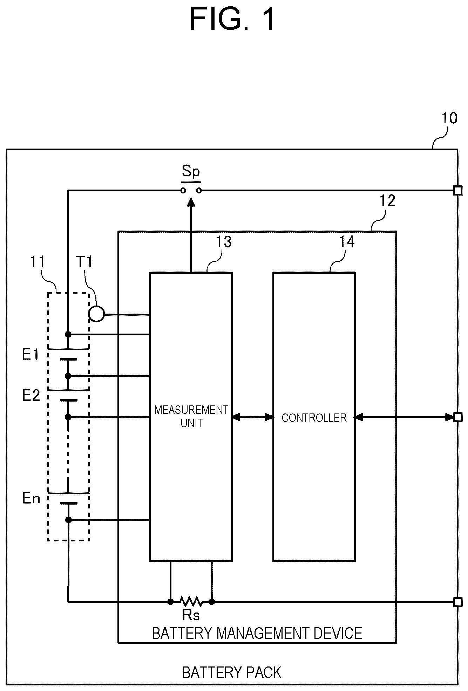

Fig. 1 is a diagram for describing the configuration of battery pack 10 according to an exemplary embodiment. Battery pack 10 can be used as a power source for electric mobility such as an electric bicycle, an electric motorcycle, or a small multicopter (also referred to as a drone). Battery pack 10 may be of a detachable portable type, or may be fixed to a device of electric mobility or the like. The application of battery pack 10 is not limited, and battery pack 10 may be mounted on any device.

Battery pack 10 includes battery module 11 and battery management device 12. Battery module 11 includes a plurality of cells E1 to En connected in series. The number of cells in series is determined by the specification of a load. Available examples of the cell include a lithium-ion battery cell, a nickel-metal-hydride battery cell, and a lead battery cell. Hereinafter, the present description assumes an example of use of lithium-ion battery cells (nominal voltage: 3.6 V to 3.7 V). In the series stage of each cell, a plurality of cells may be connected in parallel in order to increase the capacity.

Power switch Sp that switches between conduction and non-conduction with a load (not illustrated) is inserted into a power line that connects battery module 11 and the load connected to battery pack 10. A semiconductor switch or a relay can be used as power switch Sp.

Battery management device 12 includes measurement unit 13 and controller 14. Measurement unit 13 includes an analog front end (AFE) IC or an application specific integrated circuit (ASIC). Controller 14 includes a microcontroller.

Measurement unit 13 is connected to nodes of the plurality of series-connected cells E1 to En with a plurality of voltage measurement lines and measures a voltage of each of cells E1 to En by measuring a voltage between two voltage measurement lines adjacent to each other.

Measurement unit 13 includes a multiplexer and an A/D converter. The multiplexer outputs voltage values of the plurality of cells E1 to En to the A/D converter in a given order. The A/D converter converts an analog voltage input from the multiplexer into a digital value. Measurement unit 13 transmits the voltage value of each of cells E1 to En converted into a digital value to controller 14 via a serial communication interface. Note that measurement unit 13 and controller 14 may be connected with an analog communication line, and the A/D converter may be provided in controller 14.

Measurement unit 13 measures a current flowing through battery module 11. Shunt resistor Rs is connected to the power line connecting battery module 11 and the load. A differential amplifier (not illustrated) amplifies the voltage across shunt resistor Rs and outputs the amplified voltage to the A/D converter in measurement unit 13. The A/D converter converts an analog voltage, which is input from the differential amplifier and indicates a current flowing through battery module 11, into a digital value. Measurement unit 13 transmits the current value converted into the digital value to controller 14 via the serial communication interface. Note that measurement unit 13 and controller 14 may be connected with an analog communication line, and the A/D converter may be provided in controller 14.

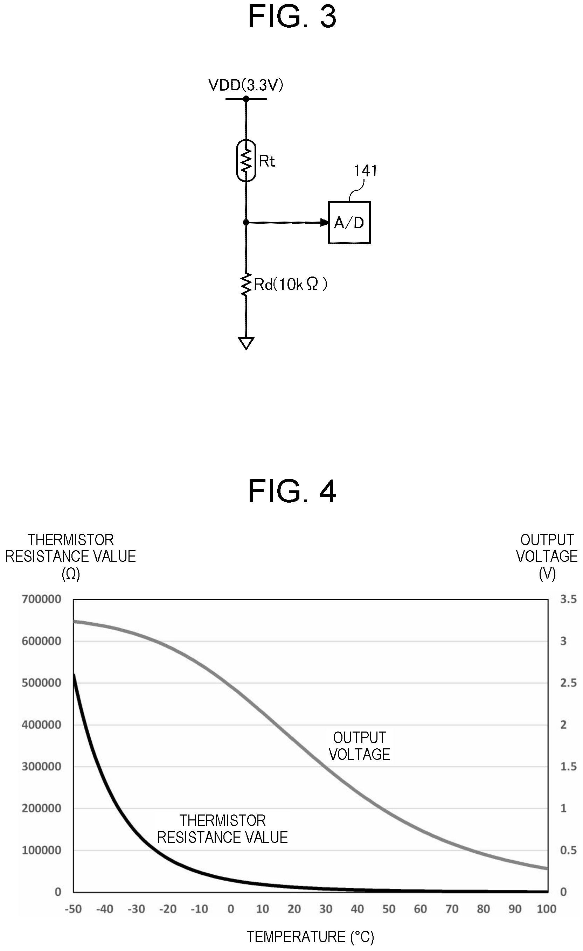

Temperature sensor T1 is installed on a surface of battery module 11. A divided voltage of temperature sensor T1 and a voltage-dividing resistor (see Fig. 3) is input to measurement unit 13. The A/D converter in measurement unit 13 converts the input analog voltage indicating a temperature into a digital value. Measurement unit 13 transmits the temperature value converted into the digital value to controller 14 via the serial communication interface. Note that measurement unit 13 and controller 14 may be connected with an analog communication line, and the A/D converter may be provided in controller 14.

Controller 14 manages the states of cells E1 to En based on the voltage values of cells E1 to En, the value of current flowing through battery module 11, and the temperature value of battery module 11, those of which are received from measurement unit 13. When detecting any one of overcharge, overdischarge, overcurrent, high-temperature abnormality, and low-temperature abnormality, controller 14 transmits a shut-off signal of power switch Sp to measurement unit 13 to turn off power switch Sp.

Controller 14 can estimate the SOC by a combination of an open circuit voltage (OCV) method and a current integration method. The OCV method is a method for estimating the SOC based on the OCV of a cell to be measured and the SOC-OCV curve of the cell. The SOC-OCV curve of the cell is created in advance based on a characteristic test performed by a battery manufacturer, and is registered in controller 14 at the time of shipment.

The current integration method is a method for estimating the SOC based on the OCV at the start of charging and discharging of a cell and an integration value of a measured current. The current integration method causes accumulation of measurement errors of the current as the charging and discharging time increases. Thus, it is preferable to use a weighted average of the SOC estimated by the current integration method and the SOC estimated by the OCV method. When estimating the SOC, controller 14 preferably corrects the SOC according to the temperature measured by temperature sensor T1.

In the present exemplary embodiment, in order to determine the reliability of the measurement value of temperature sensor T1, a mechanism for determining the influence of noise on the measurement value of temperature sensor T1 is introduced. The noise entering temperature sensor T1 includes normal mode noise and common mode noise.

Fig. 2A is a diagram illustrating a propagation path of normal mode noise entering temperature sensor T1. Fig. 2B is a diagram illustrating a propagation path of common mode noise entering temperature sensor T1. In the following, the present exemplary embodiment will describe an example of using temperature sensor T1 including thermistor Rt having NTC characteristics.

As illustrated in Fig. 2A, when noise is superimposed on a signal line connecting measurement unit 13 and temperature sensor T1, normal mode noise occurs. The normal mode noise propagates so as to circulate through a positive signal line and a negative signal line connecting measurement unit 13 and temperature sensor T1.

As illustrated in Fig. 2B, a path through which a high-frequency current flows via parasitic capacitance Cp between a housing ground and a substrate on which a signal line connecting measurement unit 13 and temperature sensor T1 is mounted is formed. When high-frequency noise is superimposed on the path formed between the substrate and the housing ground, common mode noise occurs. The common mode noise itself does not give a potential difference to thermistor Rt, and thus, it does not cause any problem. However, in a case in which there is a section where the characteristic impedance is discontinuous due to, for example, a structural difference between the substrate and a harness, the common mode noise is converted into normal mode noise, and a high-frequency current flows through thermistor Rt.

Fig. 3 is a diagram illustrating an electrical connection mode of thermistor Rt. Thermistor Rt is used by being connected in series with voltage-dividing resistor Rd. A series circuit of thermistor Rt and voltage-dividing resistor Rd is connected between power source potential VDD that supplies a bias voltage to thermistor Rt and a ground electric potential. The divided voltage of thermistor Rt and voltage-dividing resistor Rd is output to A/D converter 141 as a value indicating the temperature to be measured by thermistor Rt.

Resistance value Rs of thermistor Rt having NTC characteristics can be calculated by following (Expression 1).$Rs = Rref ⋅ exp \left(B*\left(\left(1/Te\right)-\left(1/Tref\right)\right)\right)$
Te: temperature (K)
Rs: resistance value (Ω) of thermistor at temperature Te
Tref: reference temperature (K)
Rref: reference resistance value (Ω) at reference temperature Tref
B: constant (physical property value representing sensitivity of thermistor to temperature change)

Fig. 4 is a graph showing a relationship between a temperature and a resistance value of a certain thermistor, and a relationship between the resistance value of the thermistor and an output voltage. The used thermistor has a reference resistance value set to 10 kΩ and a B constant set to 3500 at a temperature of 25°C.
Tref: 298 (K) = 25(°C) + 273
Rref: 10000 (Ω)
B: 3500

When these values are substituted into the above (Expression 1), the following (Expression 2) is obtained, and the relationship between the temperature and the thermistor resistance value shown in Fig. 4 is obtained from the following (Expression 2).$Rs = 10000 ⋅ exp \left(3500*\left(\left(1/Te\right)-\left(1/298\right)\right)\right)$

The thermistor is used as thermistor Rt in Fig. 3, and the divided voltage in a case where the bias voltage supplied to thermistor Rt is set to 3.3 V and the resistance value of voltage-dividing resistor Rd is set to 10 kΩ is the output voltage illustrated in Fig. 4. Controller 14 can estimate the temperature to be measured by thermistor Rt based on the output voltage value converted by A/D converter 141 and the characteristics illustrated in Fig. 4.

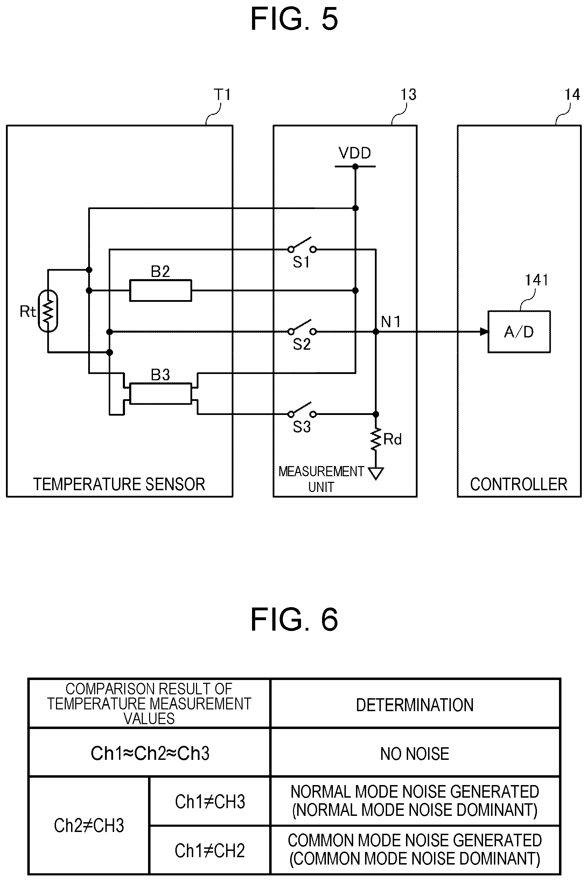

Fig. 5 is a diagram illustrating a first configuration example of a temperature measurement system in battery pack 10 according to the exemplary embodiment. In battery pack 10 according to the present exemplary embodiment, controller 14 acquires a measurement value from temperature sensor T1 via signal lines of a plurality of systems. In the first configuration example, the measurement value is acquired via signal lines of three systems.
(1) The first system is a system in which a high-frequency filter (high-frequency noise filter) is provided neither on a positive signal line connected to one of terminals of thermistor Rt nor a negative signal line connected to the other terminal of thermistor Rt.
(2) The second system is a system in which a high-frequency filter is provided on either a positive signal line connected to one of terminals of thermistor Rt and a negative signal line connected to the other terminal of thermistor Rt.
(3) The third system is a system in which a high-frequency filter is provided on both a positive signal line connected to one of terminals of thermistor Rt and a negative signal line connected to the other terminal of thermistor Rt.

The positive signal lines of the three systems connect the positive electrode of thermistor Rt and the power source potential in parallel. The negative signal lines of the three systems connect the negative electrode of thermistor Rt and voltage-dividing point N1 in parallel. The voltage at voltage-dividing point N1 is output to A/D converter 141 in controller 14.

In the present exemplary embodiment, ferrite beads B2 and B3 are used as the high-frequency filter. In the second system, ferrite bead B2 is inserted into the positive signal line. In the third system, ferrite bead B3 is inserted into both the positive signal line and the negative signal line.

Ferrite beads B2 and B3 reduce noise by converting magnetic energy generated by noise current into heat. As a result, ferrite beads B2 and B3, that is, the high-frequency filters, function as a high-frequency noise filter that reduces the normal mode noise and the common mode noise. As ferrite beads B2 and B3 are installed at positions as close as possible to thermistor Rt, the effect of reducing noise is increased. As the high-frequency filter, a choke coil or a damping resistor may be used instead of the ferrite bead.

A selection switch is connected to the signal line of each system. In the first configuration example, first selection switch S1 is connected to the negative signal line of the first system, and second selection switch S2 is connected to the negative signal line of the second system. Third selection switch S3 is connected to the negative signal line of the third system at a position closer to voltage-dividing point N1 than ferrite bead B3.

Analog switches (e.g., a MOSFETs) are used as first selection switch S1 to third selection switch S3. Controller 14 transmits control signals of first selection switch S1 to third selection switch S3 to measurement unit 13 to switch first selection switch S1 to third selection switch S3 in a time division manner. Controller 14 acquires measurement values via the respective systems in a time division manner.

Regarding the common mode noise, the propagation direction of noise is the same between the positive signal line and the negative signal line of thermistor Rt. Therefore, in the third system, the magnetic fluxes generated by the self-induction action of ferrite bead B3 are strengthened to increase the impedance, whereby the common mode noise is reduced. On the other hand, normal mode noise propagates in opposite directions between the positive signal line and the negative signal line of thermistor Rt. Therefore, the magnetic fluxes generated by ferrite bead B3 flow in opposite directions and cancel each other to decrease the impedance, so that the normal mode noise is not reduced. In the second system, the normal mode noise is reduced by the impedance of ferrite bead B2, but noise in the common mode noise circulating through the negative signal line and the ground is not reduced. In the first system, neither normal mode noise nor common mode noise is reduced. Controller 14 uses such properties to determine whether or not noise is included in the measurement value by comparing two or more measurement values acquired from the signal lines of the plurality of systems.

Fig. 6 is a graph illustrating comparison results of temperature measurement values acquired from the signal lines of the three systems and determination details according to the comparison results. In a case where the measurement value (hereinafter, referred to as Ch1 measurement value) acquired from the signal line of the first system, the measurement value (hereinafter, referred to as Ch2 measurement value) acquired from the signal line of the second system, and the measurement value (hereinafter, referred to as Ch3 measurement value) acquired from the signal line of the third system are substantially equal, controller 14 determines that the measurement value does not include significant noise.

In a case where the difference between Ch2 measurement value and Ch3 measurement value is greater than or equal to a first set value, and the difference between Ch1 measurement value and Ch3 measurement value is greater than or equal to a second set value, controller 14 determines that the normal mode noise is predominantly included in Ch1 measurement value. The first set value is set to an allowable value for regarding Ch2 measurement value as substantially equal to Ch3 measurement value, and the second set value is set to an allowable value for regarding Ch1 measurement value as substantially equal to Ch3 measurement value. The first set value and the second set value may be set to equal values, or may be set to different values.

In a case where the difference between Ch2 measurement value and Ch3 measurement value is greater than or equal to the first set value, and the difference between Ch1 measurement value and Ch2 measurement value is greater than or equal to a third set value, controller 14 determines that the common mode noise is predominantly included in Ch1 measurement value. The third set value is set to an allowable value for regarding Ch1 measurement value as substantially equal to Ch2 measurement value. The first set value, the second set value, and the third set value may be set to equal values, or may be set to different values.

Controller 14 treats the temperature measurement value in the period in which it is determined that Ch1 measurement value includes significant noise as an invalid value, and performs processing so as not to reflect the temperature measurement value in calculation or control. In a case where a state in which it is determined that Ch1 measurement value includes significant noise continues for a certain period of time, controller 14 determines that an abnormality has occurred in any part of the temperature measurement system. For example, there is a possibility that temperature sensor T1 or measurement unit 13 has failed.

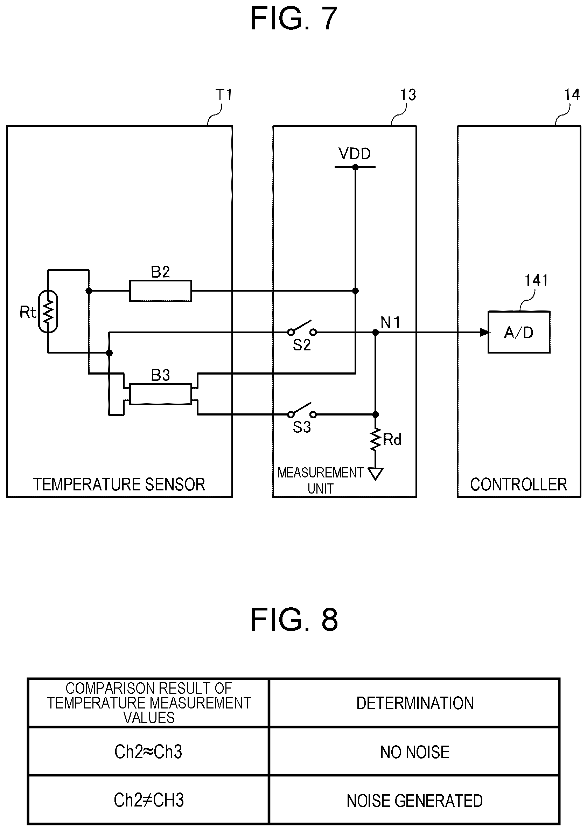

Fig. 7 is a diagram illustrating a second configuration example of the temperature measurement system in battery pack 10 according to the exemplary embodiment. In the second configuration example, controller 14 acquires measurement values via signal lines of two systems, the second system and the third system.

Fig. 8 is a graph illustrating comparison results of temperature measurement values acquired from the signal lines of the two systems and determination details according to the comparison results. In a case where the difference between Ch2 measurement value and Ch3 measurement value is less than the first set value, controller 14 determines that the measurement value does not include significant noise.

In a case where the difference between Ch2 measurement value and Ch3 measurement value is equal to or greater than the first set value, controller 14 determines that the measurement value includes significant noise. In the second configuration example, it is not possible to specify which one of the normal mode noise and the common mode mode is dominant.

Controller 14 treats the temperature measurement value in the period in which it is determined that Ch2 measurement value or Ch3 measurement value includes significant noise as an invalid value, and performs processing so as not to reflect the temperature measurement value in calculation or control. In a case where a state in which it is determined that Ch2 measurement value or Ch3 measurement value includes significant noise continues for a certain period of time, controller 14 determines that an abnormality has occurred in any part of the temperature measurement system.

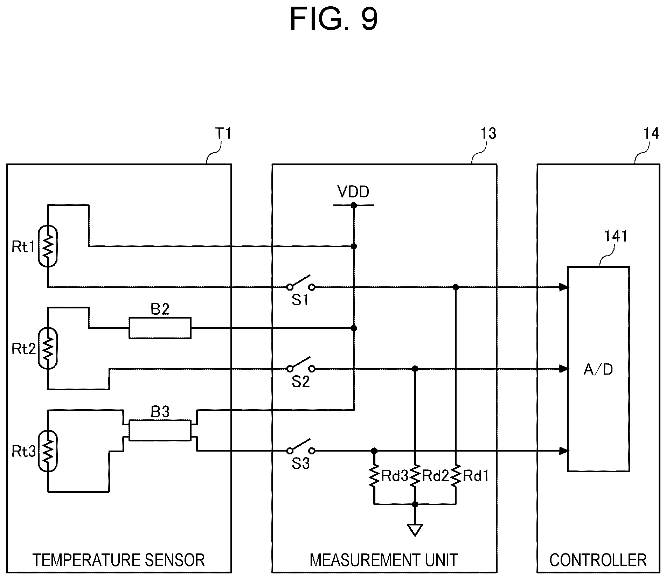

Fig. 9 is a diagram illustrating a third configuration example of the temperature measurement system in battery pack 10 according to the exemplary embodiment. In the third configuration example, thermistor Rt is installed for each system. In a case where three systems are provided as illustrated in Fig. 9, first thermistor Rt1, second thermistor Rt2, and third thermistor Rt3 are arranged side by side at adjacent positions.

From the first system, the divided voltage of first thermistor Rt1 and first voltage-dividing resistor Rd1 is output as Ch1 measurement value. From the second system, the divided voltage of second thermistor Rt2 and second voltage-dividing resistor Rd2 is output as Ch2 measurement value. From the third system, the divided voltage of third thermistor Rt3 and third voltage-dividing resistor Rd3 is output as Ch3 measurement value.

In a case where first thermistor Rt1, second thermistor Rt2, and third thermistor Rt3 have the same characteristics, voltage-dividing resistors Rd can be shared as illustrated in Figs. 5 and 7. In a case where there is an error in the characteristics among first thermistor Rt1, second thermistor Rt2, and third thermistor Rt3, the error can be adjusted by changing the resistance values of first voltage-dividing resistor Rd1, second voltage-dividing resistor Rd2, and third voltage-dividing resistor Rd3. Other circuit configurations and operations are similar to those of the first configuration example illustrated in Figs. 5 and 6. In a case where first thermistor Rt1, first voltage-dividing resistor Rd1, and the signal line of the first system are not provided, the circuit configuration and operation thereof are similar to those of the second configuration example illustrated in Figs. 7 and 8.

As described above, according to the present exemplary embodiment, the influence of noise on the measurement value of the temperature sensor can be determined with high accuracy by comparing the temperature measurement values of the plurality of systems that vary in connection status of high-frequency filter. In the first and third configuration examples, it is also possible to specify whether the normal mode noise is dominant or the common mode noise is dominant. In the first and second configuration examples, even when only one thermistor Rt is installed, the influence of noise on the measurement value can be determined, and thus general-purpose properties are high.

The present disclosure has been described above based on the exemplary embodiment. It is to be understood by the person of ordinary skill in the art that the exemplary embodiment is merely an example, that various modified examples are possible by combining configuration elements and processing processes of the embodiment, and that such modified examples are also within the scope of the present disclosure.

The above exemplary embodiment has described an example in which temperature sensor T1 is installed on the surface of battery module 11 to measure the temperature of battery module 11. In this respect, temperature sensors may be installed at a plurality of locations of battery module 11 to measure the temperature in units of one cell or several cells.

In addition, the temperature sensor may be installed at a predetermined position of a section other than battery module 11 in battery pack 10. For example, the temperature sensor may be installed on the substrate of measurement unit 13 to measure the temperature of the substrate. Alternatively, the temperature sensor may be installed near power switch Sp to measure the temperature of power switch Sp.

The above exemplary embodiment has described an example of using temperature sensor T1 including thermistor Rt. In this respect, a temperature sensor including a thermocouple may be used. When a thermocouple is used, different metal wires are used for the positive signal line and the negative signal line. An electromotive force corresponding to a temperature difference between a measurement point and a reference point is generated between the positive signal line and the negative signal line. Since the generated electromotive force is weak, the voltage generated between the positive signal line and the negative signal line is amplified by an amplifier (not illustrated) and output to A/D converter 141.

The above exemplary embodiment has described an example of using battery pack 10 incorporating battery module 11. In this respect, a capacitor pack incorporating a capacitor module including an electric double layer capacitor cell and a lithium ion capacitor cell may be used. In this specification, the battery pack and the capacitor pack are collectively referred to as a power storage pack.

The exemplary embodiment may be specified by the following items.

### [Item 1]

Power storage pack (10) including:
temperature sensor (T1) that measures a temperature at a predetermined position in power storage pack (10); and
controller (14) that acquires measurement values from temperature sensor (T1) via signal lines of a plurality of systems, wherein
the signal lines of the plurality of systems comprise signal lines of two or more systems selected from the group consisting of
   a first system in which no high-frequency filter is provided on both a positive signal line connected to one of terminals of temperature sensor (T1) and a negative signal line connected to another of the terminals,
   a second system in which high-frequency filter (B2) is provided on either a positive signal line connected to one of terminals of temperature sensor (T1) or a negative signal line connected to another of the terminals, or
   a third system in which high-frequency filter (B3) is provided on both a positive signal line connected to one of terminals of temperature sensor (T1) and a negative signal line connected to another of the terminals, and
controller (14) compares two or more measurement values acquired from the signal lines of the two or more systems to determine whether at least one of the measurement values includes noise.

With this configuration, it is possible to determine with high accuracy whether the measurement value of temperature sensor (T1) includes noise.

### [Item 2]

Power storage pack (10) according to Item 1, wherein
the signal lines of the plurality of systems comprise signal lines of two systems that are the second system and the third system, and
controller (14) determines, when a difference between two measurement values acquired from the signal lines of the two systems is greater than or equal to a set value, that at least one of the two measurement values includes noise.

With this configuration, it is possible to determine with high accuracy whether the measurement value of temperature sensor (T1) includes noise, while minimizing the addition of components.

### [Item 3]

Power storage pack (10) according to Item 1, wherein
the signal lines of the plurality of systems comprise signal lines of three systems that are the first system, the second system, and the third system, and
controller (14)
   determines, when a difference between a measurement value acquired from the signal lines of the second system and a measurement value acquired from the signal lines of the third system is greater than or equal to a first set value and when a difference between a measurement value acquired from the signal lines of the first system and the measurement value acquired from the signal lines of the third system is greater than or equal to a second set value, that the measurement value acquired from the signal lines of the first system includes normal mode noise, and
   determines, when the difference between the measurement value acquired from the signal lines of the second system and the measurement value acquired from the signal lines of the third system is greater than or equal to the first set value and when a difference between the measurement value acquired from the signal lines of the first system and the measurement value acquired from the signal lines of the second system is greater than or equal to a third set value, that the measurement value acquired from the signal line of the first system includes common mode noise.

With this configuration, it is possible to specify whether the normal mode noise is dominant or the common mode noise is dominant.

### [Item 4]

Power storage pack (10) according to Item 1, wherein
the signal lines of the plurality of systems are respectively connected to switches (S1 to S3), and
controller (14) switches switches (S1 to S3) respectively connected to the signal lines of the plurality of systems in a time-division manner to acquire the measurement values via the respective systems in a time-division manner.

With this configuration, an A/D converter installed at the subsequent stage can be shared by the plurality of systems.

### [Item 5]

Power storage pack (10) according to Item 1, wherein
controller (14) processes a measurement value acquired in a period in which it is determined that the measurement value includes noise as an invalid value.

With this configuration, the occurrence of a control error can be prevented.

### [Item 6]

Power storage pack (10) according to Item 1, wherein
controller (14) determines, when a state in which at least one of the measurement values is determined to include noise continues for a certain period of time, that an abnormality has occurred in any part of a temperature measurement system.

With this configuration, it is possible to monitor whether or not noise occurs and simultaneously perform failure diagnosis.

### [Item 7]

Power storage pack (10) according to Item 1 further including power storage module (11) including a plurality of cells (E1 to En), wherein
temperature sensor (T1) is installed in power storage module (11).

With this configuration, it is possible to measure the temperature of power storage module (11) with high accuracy.

### [Item 8]

Power storage pack (10) according to Item 1, wherein
high-frequency filter (B2, B3) is ferrite bead (B2, B3).

With this configuration, it is possible to ensure high impedance in a high-frequency region.

### REFERENCE MARKS IN THE DRAWINGS

- 10: battery pack
- 11: battery module
- 12: battery management device
- 13: measurement unit
- 14: controller
- 141: A/D converter
- T1: temperature sensor
- Rt: thermistor
- Sp: power switch
- S1-S3: selection switch
- E1-En: cell
- Rs: shunt resistor
- Rd: voltage-dividing resistor
- B2, B3: ferrite bead

## Claims

1. A power storage pack comprising:
a temperature sensor that measures a temperature at a predetermined position in the power storage pack; and
a controller that acquires measurement values from the temperature sensor via signal lines of a plurality of systems, wherein
the signal lines of the plurality of systems comprise signal lines of two or more systems selected from the group consisting of
a first system in which no high-frequency filter is provided on both a positive signal line connected to one of terminals of the temperature sensor and a negative signal line connected to another of the terminals,
a second system in which a high-frequency filter is provided on either a positive signal line connected to one of terminals of the temperature sensor or a negative signal line connected to another of the terminals, or
a third system in which a high-frequency filter is provided on both a positive signal line connected to one of terminals of the temperature sensor and a negative signal line connected to another of the terminals, and
the controller compares two or more measurement values acquired from the signal lines of the two or more systems to determine whether at least one of the measurement values includes noise.

2. The power storage pack according to Claim 1, wherein
the signal lines of the plurality of systems comprise signal lines of two systems that are the second system and the third system, and
the controller determines, when a difference between two measurement values acquired from the signal lines of the two systems is greater than or equal to a set value, that at least one of the two measurement values includes noise.

3. The power storage pack according to Claim 1, wherein
the signal lines of the plurality of systems comprise signal lines of three systems that are the first system, the second system, and the third system, and
the controller
determines, when a difference between a measurement value acquired from the signal lines of the second system and a measurement value acquired from the signal lines of the third system is greater than or equal to a first set value and when a difference between a measurement value acquired from the signal lines of the first system and the measurement value acquired from the signal lines of the third system is greater than or equal to a second set value, that the measurement value acquired from the signal lines of the first system includes normal mode noise, and
determines, when the difference between the measurement value acquired from the signal lines of the second system and the measurement value acquired from the signal lines of the third system is greater than or equal to the first set value and when a difference between the measurement value acquired from the signal lines of the first system and the measurement value acquired from the signal lines of the second system is greater than or equal to a third set value, that the measurement value acquired from the signal lines of the first system includes common mode noise.

4. The power storage pack according to Claim 1, wherein
the signal lines of the plurality of systems are respectively connected to switches, and
the controller switches the switches respectively connected to the signal lines of the plurality of systems in a time-division manner to acquire the measurement values via the respective systems in a time-division manner.

5. The power storage pack according to Claim 1, wherein
the controller processes, as an invalid value, a measurement value acquired in a period in which it is determined that the measurement value includes noise.

6. The power storage pack according to Claim 1, wherein
the controller determines, when a state in which at least one of the measurement values is determined to include noise continues for a certain period of time, that an abnormality has occurred in any part of a temperature measurement system including the temperature sensor, the plurality of systems, and the controller.

7. The power storage pack according to Claim 1 further comprising a power storage module including a plurality of cells, wherein
the temperature sensor is installed in the power storage module.

8. The power storage pack according to Claim 1, wherein
the high-frequency filter is a ferrite bead.
